# EUROPEAN PATENT APPLICATION

(11) **EP 4 686 363 A1**
(43) Date of publication of application: **28.01.2026**
(21) Application number: 25188188.4
(22) Date of filing: 08.07.2025
(51) Int. Cl.: H10K 59/80

(54) **DISPLAY DEVICE AND ELECTRONIC DEVICE INCLUDING THE SAME**

(30) Priority: 22.07.2024 KR 20240096260
(71) Applicant: Samsung Display Co., Ltd., Yongin-si, Gyeonggi-do 17113 (KR)
(72) Inventor: LAZO MARTINEZ, Israel Esteban, Yongin-si (KR); KIM, Kyeongjong, Yongin-si (KR); KIM, Su Jeong, Yongin-si (KR); KIM, Wooyoung, Yongin-si (KR); LEE, Jung-Woo, Yongin-si (KR); LEE, Jinhyeong, Yongin-si (KR)
(74) Representative: Marks & Clerk LLP

(57) **Abstract**

A display device includes a light emitting element including a pixel electrode; a pixel defining layer defining a pixel opening exposing at least a portion of the pixel electrode; a light blocking pattern arranged on the light emitting element, overlapping the pixel opening in a plan view, and having a width of about 4 micrometers to about 20 micrometers in one direction; and a reflective pattern arranged on the light emitting element, overlapping the pixel opening in the plan view, and covered by the light blocking pattern in the plan view.

## Description

### BACKGROUND

### 1. Field

Aspects of the present disclosure relate generally to a display device. More particularly, the present disclosure relates to a display device that provides visual information and an electronic device including the same.

### 2. Description of the Related Art

With the development of information technology, the importance of a display device, which is a connection medium between a user and information, has been highlighted. As the display device includes lines, electrodes, etc. that include a metal, external light incident on the display device may be reflected from the lines, the electrodes, etc. To prevent such reflection by external light, a display device generally includes a polarizer. However, although the polarizer can prevent reflection by external light, the light efficiency of the display device may be reduced due to the polarizer.

The above information disclosed in this Background section is only for enhancement of understanding of the background of the invention and therefore it may contain information that does not form.

### SUMMARY

Aspects of some embodiments of the present disclosure are directed to a display device with improved display quality.

Aspects of some embodiments of the present disclosure are directed to an electronic device including the display device.

According to some embodiments of the present disclosure, there is provided a display device including: a light emitting element including a pixel electrode; a pixel defining layer defining a pixel opening exposing at least a portion of the pixel electrode; a light blocking pattern arranged on the light emitting element, overlapping the pixel opening in a plan view, and having a width of about 4 micrometers to about 20 micrometers in one direction; and a reflective pattern arranged on the light emitting element, overlapping the pixel opening in the plan view, and covered by the light blocking pattern in the plan view.

In some embodiments, the light blocking pattern may have a width of about 4 micrometers to about 15 micrometers in the one direction.

In some embodiments, a planar shape of the light blocking pattern may be a ring shape.

In some embodiments, a light blocking pattern unit may include a set of the light blocking patterns, and the light blocking pattern unit may overlap the pixel opening in the plan view.

In some embodiments, an upper surface of the light blocking pattern may have an uneven structure.

In some embodiments, the light blocking pattern may include: a base layer including a light blocking material; and scattering particles that are nano-sized and are dispersed within the base layer.

In some embodiments, the light blocking pattern may include: a base layer including a light blocking material; and pigment particles that are nano-sized and are dispersed within the base layer.

In some embodiments, the display device may further include: a first touch insulating layer arranged on the light emitting element; a first touch electrode arranged on the first touch insulating layer; a second touch insulating layer covering the first touch electrode; and a second touch electrode arranged on the second touch insulating layer and electrically connected to the first touch electrode, wherein the light blocking pattern is arranged on the second touch insulating layer.

In some embodiments, the reflective pattern may include a conductive material.

In some embodiments, the reflective pattern may include: a resin layer arranged on the first touch insulating layer and covered by the second touch insulating layer; and scattering particles that are nano-sized and are dispersed within the resin layer.

In some embodiments, the reflective pattern may include: resin patterns arranged on the first touch insulating layer and arranged at an interval from each other; and air gap patterns defined by the interval of the resin patterns.

In some embodiments, a refractive index of the first touch insulating layer may be greater than a refractive index of air within the air gap patterns.

In some embodiments, the reflective pattern may be an air gap defined between the first touch insulating layer and the second touch insulating layer. A refractive index of the first touch insulating layer may be greater than a refractive index of air within the air gap.

In some embodiments, the reflective pattern may be an insulating pattern arranged to fill an air gap defined between the first touch insulating layer and the second touch insulating layer. A refractive index of the first touch insulating layer may be greater than a refractive index of the insulating pattern, or a refractive index of the second touch insulating layer may be smaller than the refractive index of the insulating pattern.

In some embodiments, a lower surface of the reflective pattern may have an uneven structure.

In some embodiments, the display device may further include: a light blocking member arranged on the pixel defining layer, overlapping the pixel defining layer in the plan view, and defining an opening area corresponding to the pixel opening; and a color filter layer arranged in the opening area and configured to selectively transmit light of a specific color, wherein the light blocking pattern is arranged in the opening area and is covered by the color filter layer.

In some embodiments, the light blocking pattern may include a same material as the light blocking member.

According to some embodiments of the present disclosure, there is provided a display device including: a light emitting element including a pixel electrode; a pixel defining layer defining a pixel opening exposing at least a portion of the pixel electrode; a light blocking member arranged on the pixel defining layer, overlapping the pixel defining layer in a plan view, and defining an opening area corresponding to the pixel opening; a light blocking pattern unit arranged in the opening area on the light emitting element, overlapping the pixel opening in the plan view, and defined by a set of light blocking patterns; a color filter layer arranged in the opening area on the light emitting element, configured to selectively transmit light of a specific color, and covering the light blocking pattern unit; and a reflective pattern arranged on the light emitting element, overlapping the pixel opening in the plan view, and covered by the light blocking pattern unit in the plan view.

In some embodiments, each of the light blocking patterns may have a width of about 4 micrometers to about 20 micrometers in one direction, and a planar shape of each of the light blocking patterns may be circular, elliptical, polygonal, or track-shaped.

According to some embodiments of the present disclosure, there is provided an electronic device including: a display device including a light emitting element; and a power module configured to provide power to the display device, wherein the display device includes: the light emitting element including a pixel electrode; a pixel defining layer defining a pixel opening exposing at least a portion of the pixel electrode; a light blocking pattern arranged on the light emitting element, overlapping the pixel opening in a plan view, and having a width of about 4 micrometers to about 20 micrometers in one direction; and a reflective pattern arranged on the light emitting element, overlapping the pixel opening in the plan view, and covered by the light blocking pattern in the plan view.

At least some of the above and other features of the invention are set out in the claims.

A display device according to some embodiments of the present disclosure may not include a polarizer by including a light blocking member and a color filter layer. Accordingly, the weight and/or thickness of the display device may be reduced. In addition, the visibility of the display device may be improved (e.g., increased).

In addition, the display device may include a light blocking pattern covered by the color filter layer. The light blocking pattern may absorb external light. Accordingly, the external light reflectance of the display device may be reduced, and the reflected color may be improved (e.g., become less perceivable to a user). Accordingly, the display quality of the display device may be improved (e.g., increased).

In addition, the display device may include a reflective pattern covered by the light blocking pattern in a plan view. Accordingly, a portion of light emitted from a light emitting element may be reflected by the reflective pattern, and a portion of light reflected from the reflective pattern may be reflected again by structures under the reflective pattern (e.g., a common electrode of the light emitting element, etc.) and may be emitted to the outside. Accordingly, the recycling efficiency of light emitted from the light emitting element may be improved (e.g., increased).

In addition, the light blocking pattern according to some embodiments of the present disclosure may have a width of about 4 micrometers to about 20 micrometers in one direction. Accordingly, the recycling efficiency of light emitted from the light emitting element may be further improved through the light blocking pattern and the reflective pattern.

### BRIEF DESCRIPTION OF THE DRAWINGS

Illustrative, non-limiting embodiments will be more clearly understood from the following detailed description in conjunction with the accompanying drawings.
FIG. 1 is a plan view illustrating a display device according to some embodiments of the present disclosure.
FIG. 2 is an enlarged view illustrating an example of the area A of FIG. 1 according to some embodiments of the present disclosure.
FIG. 3 is a cross-sectional view illustrating an example cut along the line I-I' of FIG. 2 according to some embodiments of the present disclosure.
FIG. 4 is a cross-sectional view illustrating another example cut along the line I-I' of FIG. 2 according to some embodiments of the present disclosure.
FIG. 5 is a cross-sectional view illustrating still another example cut along the line I-I' of FIG. 2 according to some embodiments of the present disclosure.
FIG. 6 is a cross-sectional view illustrating still another example cut along the line I-I' of FIG. 2 according to some embodiments of the present disclosure.
FIG. 7 is a cross-sectional view illustrating still another example cut along the line I-I' of FIG. 2 according to some embodiments of the present disclosure.
FIG. 8 is a cross-sectional view illustrating still another example cut along the line I-I' of FIG. 2 according to some embodiments of the present disclosure.
FIG. 9 is a cross-sectional view illustrating still another example cut along the line I-I' of FIG. 2 according to some embodiments of the present disclosure.
FIG. 10 is a cross-sectional view illustrating still another example cut along the line I-I' of FIG. 2 according to some embodiments of the present disclosure.
FIG. 11 is a cross-sectional view illustrating still another example cut along the line I-I' of FIG. 2 according to some embodiments of the present disclosure.
FIG. 12 is an enlarged view illustrating another example of the area A of FIG. 1 according to some embodiments of the present disclosure.
FIG. 13 is a cross-sectional view illustrating an example cut along the line II-II' of FIG. 12 according to some embodiments of the present disclosure.
FIG. 14 is an enlarged view illustrating still another example of the area A of FIG. 1 according to some embodiments of the present disclosure.
FIG. 15 is a block diagram of an electronic device according to some embodiments of the present disclosure.
FIG. 16 is a schematic diagram of an electronic device according to some embodiments of the present disclosure.

### DETAILED DESCRIPTION

Hereinafter, embodiments of the present disclosure will be described in detail with reference to the accompanying drawings. The same reference numerals are used for the same components in the drawings, and redundant descriptions of the same components may be omitted.

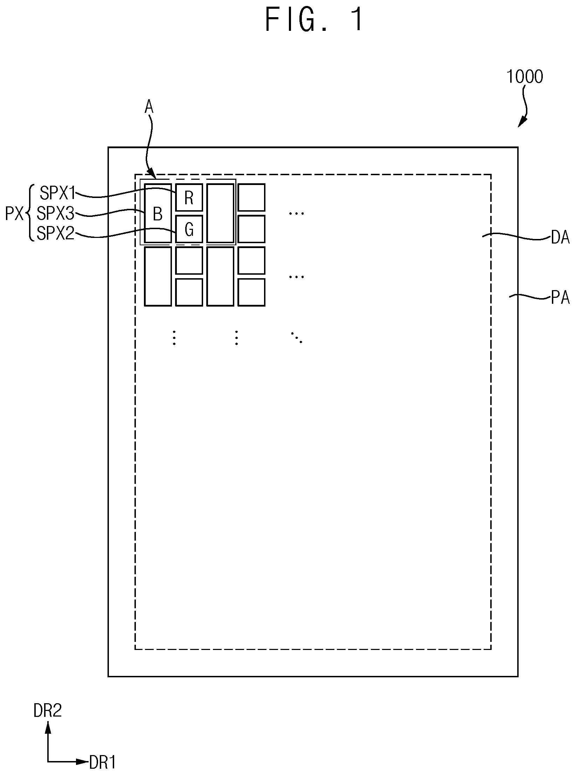

FIG. 1 is a plan view illustrating a display device according to some embodiments of the present disclosure.

Referring to FIG. 1, a display device 1000 according to some embodiments of the present disclosure may include a display area DA and a peripheral area PA. The display area DA may be an area that displays an image. The peripheral area PA may be an area that does not display an image. The peripheral area PA may be located around a periphery of the display area DA. For example, the peripheral area PA may entirely surround the display area DA.

The display device 1000 may include a plurality of pixels PX arranged in the display area DA. In a plan view, the pixels PX may be arranged repeatedly along a first direction DR1 and a second direction DR2. The second direction DR2 may be orthogonal to the first direction DR1.

Each of the pixels PX may include a plurality of sub-pixels that emit light of different colors. In some embodiments, each of the pixels PX may include first to third sub-pixels SPX1, SPX2, and SPX3 that emit light of different colors. For example, the first sub-pixel SPX1 may emit red light, the second sub-pixel SPX2 may emit green light, and the third sub-pixel SPX3 may emit blue light, but the present disclosure is not necessarily limited thereto. For example, the first to third sub-pixels SPX1, SPX2, and SPX3 may be combined such that each of the pixels PX emits yellow, cyan, and magenta lights.

In some embodiments, the arrangement structure of the first to third sub-pixels SPX1, SPX2, and SPX3 may be an S-stripe structure. For example, the third sub-pixel SPX3 may be arranged in a first column, and the first sub-pixel SPX1 and the second sub-pixel SPX2 may be arranged in a second column adjacent to the first column. In such examples, the third sub-pixel SPX3 may have a rectangular planar shape with a long side in the second direction DR2, and the first sub-pixel SPX1 and the second sub-pixel SPX2 may have a rectangular planar shape. In other words, one side of each of the first sub-pixel SPX1 and the second sub-pixel SPX2 may be arranged to face the long side of the third sub-pixel SPX3. However, the present disclosure is not necessarily limited thereto. In some other embodiments, the arrangement structure of the first to third sub-pixels SPX1, SPX2, and SPX3 may have a pentile structure.

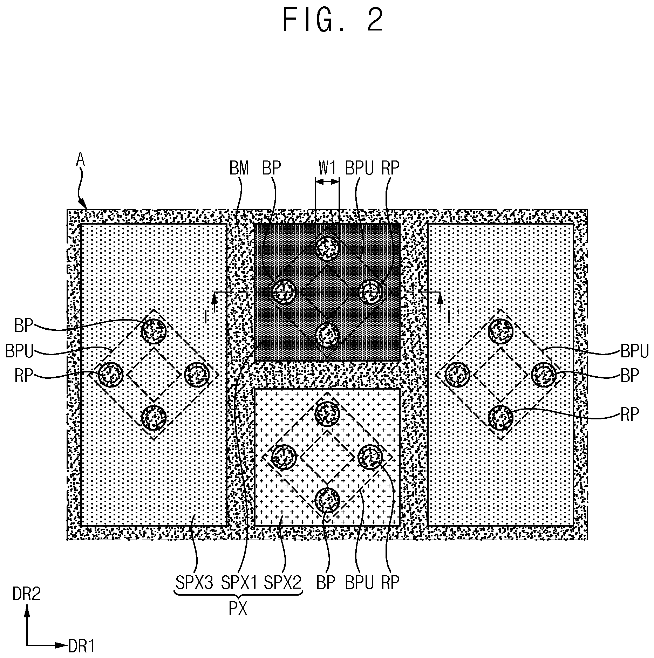

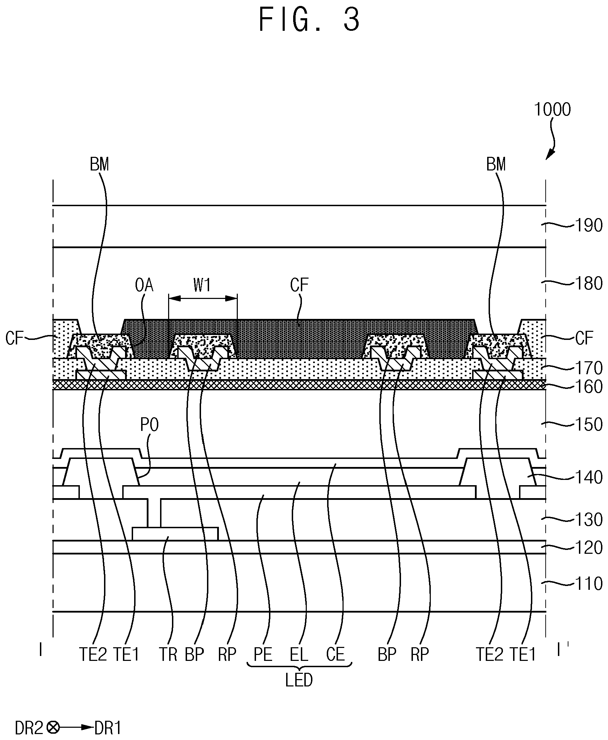

FIG. 2 is an enlarged view illustrating an example of area A of FIG. 1. FIG. 3 is a cross-sectional view illustrating an example cut along the line I-I' of FIG. 2 according to some embodiments of the present disclosure.

For example, FIG. 3 illustrates a cross-sectional structure of the first sub-pixel SPX1. A cross-sectional structure of each of the second sub-pixel SPX2 and the third sub-pixel SPX3 may be substantially equal to the cross-sectional structure of the first sub-pixel SPX1. Therefore, hereinafter, the display device 1000 according to some embodiments of the present disclosure will be described with a focus on the cross-sectional structure of the first sub-pixel SPX1.

Referring to FIGS. 2 and 3, the display device 1000 according to some embodiments of the present disclosure may include a substrate 110, a buffer layer 120, a driving element TR, an insulating structure 130, a pixel defining layer 140, a light emitting element LED, an encapsulation layer 150, a first touch insulating layer 160, a first touch electrode TE1, a second touch insulating layer 170, a second touch electrode TE2, a reflective pattern RP, a light blocking member BM, a light blocking pattern BP, a color filter layer CF, an overcoat layer 180, and a window 190.

The substrate 110 may include a transparent material or an opaque material. In some embodiments, the substrate 110 may include a first organic layer, a first barrier layer, a second organic layer, a second barrier layer, etc. In some other embodiments, the substrate SUB may include a quartz substrate, a synthetic quartz substrate, a calcium fluoride substrate, a fluorine-doped quartz substrate, a soda-lime glass substrate, a non-alkali glass substrate, etc. These may be used alone or in combination with each other.

The buffer layer 120 may be arranged on the substrate 110. The buffer layer 120 may prevent impurities such as oxygen, moisture, etc. from diffusing to an upper portion of the substrate 110 through the substrate 110. The buffer layer 120 may include an inorganic insulating material such as a silicon compound, metal oxide, or the like. The buffer layer 120 may have a single-layer structure, or may have a multi-layer structure including a plurality of insulating layers. In some other embodiments, the buffer layer 120 may be omitted.

The driving element TR may be arranged on the buffer layer 120. In some embodiments, the driving element TR may include at least one thin film transistor. A channel layer of the thin film transistor may include an oxide semiconductor, a silicon semiconductor, an organic semiconductor, or the like. For example, the oxide semiconductor may include at least one oxide selected from indium (In), gallium (Ga), tin (Sn), zirconium (Zr), vanadium (V), hafnium (Hf), cadmium (Cd), germanium (Ge), chromium (Cr), titanium (Ti), and zinc (Zn). The silicon semiconductor may include amorphous silicon, polycrystalline silicon, or the like.

The insulating structure 130 may cover the driving element TR. The insulating structure 130 may include an inorganic insulating layer and an organic insulating layer. For example, the inorganic insulating layer may include silicon oxide (SiOₓ), silicon nitride (SiNₓ), silicon carbide (SiCₓ), silicon oxynitride (SiOₓN_{y}), silicon oxycarbide (SiOₓC_{y}), or the like. In addition, the organic insulating layer may include a photoresist, a polyacryl-based resin, a polyimide-based resin, a polyamide-based resin, a siloxane-based resin, an acryl-based resin, an epoxy-based resin, or the like. These may be used alone or in combination with each other.

A pixel electrode PE may be arranged on the insulating structure 130. The pixel electrode PE may include a conductive material such as a metal, an alloy, a conductive metal nitride, a conductive metal oxide, a transparent conductive material, or the like. The pixel electrode PE may have a single-layer structure or a multi-layer structure including a plurality of conductive layers. The pixel electrode PE may be electrically connected to the driving element TR through a contact hole formed in the insulating structure 130.

The pixel defining layer 140 may be arranged on the pixel electrode PE. The pixel defining layer 140 may include an organic insulating material. Examples of the organic insulating material may include a photoresist, a polyacryl-based resin, a polyimide-based resin, a polyamide-based resin, a siloxane-based resin, an acrylic-based resin, an epoxy-based resin, or the like. These may be used alone or in combination with each other. In some embodiments, the pixel defining layer 140 may further include a light blocking material. The pixel defining layer 140 may define a pixel opening PO that exposes a portion of the pixel electrode PE. An emission area and a non-emission area of the display device 1000 may be defined by the pixel opening PO. For example, a portion in which the pixel opening PO is located may correspond to the emission area, and a portion in which the pixel defining layer 140 is arranged may correspond to the non-emission area.

A light emitting layer EL may be arranged on the pixel electrode PE exposed by the pixel opening PO of the pixel defining layer 140. In some embodiments, the light emitting layer EL included in the first sub-pixel SPX1 may include a light emitting material that emits red light. In addition, a light emitting layer included in the second sub-pixel SPX2 may include a light emitting material that emits green light, and a light emitting layer included in the third sub-pixel SPX3 may include a light emitting material that emits blue light. However, the present disclosure is not necessarily limited thereto.

In some embodiments, functional layers such as a hole injection layer, a hole transport layer, an electron transport layer, an electron injection layer, or the like may be arranged on the top and/or the bottom of each light emitting layer EL.

A common electrode CE may be arranged on the light emitting layer EL. The common electrode CE may include a conductive material such as a metal, an alloy, a conductive metal nitride, a conductive metal oxide, a transparent conductive material, or the like. The common electrode CE may have a single-layer structure, or may have a multi-layer structure including a plurality of conductive layers. In some embodiments, the common electrode CE may extend continuously across the plurality of pixels.

The pixel electrode PE, the light emitting layer EL, and the common electrode CE may configure the light emitting element LED. In some embodiments, the light emitting element LED included in the first sub-pixel SPX1 may emit red light. In addition, a light emitting element included in the second sub-pixel SPX2 may emit green light, and a light emitting element included in the third sub-pixel SPX3 may emit blue light. A light emitting element included in the display device 1000 may be an organic light emitting element, an inorganic light emitting element, or a quantum dot light emitting element.

The encapsulation layer 150 may be arranged on the common electrode CE. The encapsulation layer 150 may include at least one inorganic encapsulation layer and at least one organic encapsulation layer. In some embodiments, the encapsulation layer 150 may include a first inorganic encapsulation layer arranged on the common electrode CE, an organic encapsulation layer arranged on the first inorganic encapsulation layer, and a second inorganic encapsulation layer arranged on the organic encapsulation layer. The encapsulation layer 150 may cover the light emitting element LED, and may protect the light emitting element LED from external foreign substances.

The first touch insulating layer 160 may be arranged on the encapsulation layer 150. The first touch insulating layer 160 may include an inorganic insulating material and/or an organic insulating material. For example, the first touch insulating layer 160 may include silicon oxide (SiOₓ), silicon nitride (SiNₓ), silicon oxynitride (SiOₓN_{y}), or the like. These may be used alone or in combination with each other.

The first touch electrode TE1 may be arranged on the first touch insulating layer 160. In some embodiments, the first touch electrode TE1 may be arranged in the non-emission area. In other words, the first touch electrode TE1 may overlap the pixel defining layer 140 in a plan view. The first touch electrode TE1 may include a conductive material such as a metal, an alloy, a conductive metal oxide, or the like. Examples of materials that may be used as the first touch electrode TE1 may include silver (Ag), alloys containing silver, molybdenum (Mo), alloys containing molybdenum, aluminium (Al), alloys containing aluminium, aluminium nitride (AIN), tungsten (W), tungsten nitride (WN), copper (Cu), nickel (Ni), chromium (Cr), chromium nitride (CrN), titanium (Ti), tantalum (Ta), platinum (Pt), scandium (Sc), or the like. They may be used alone or in combination with each other.

In some embodiments, the first touch electrode TE1 may have a multi-layer structure with a plurality of conductive layers that are stacked. For example, the first touch electrode TE1 may have a two-layer structure of titanium (Ti)/aluminium (Al), a two-layer structure of aluminium (Al)/molybdenum (Mo), a two-layer structure of titanium (Ti)/copper (Cu), or the like.

The second touch insulating layer 170 may cover the first touch electrode TE1 and may be arranged on the first touch insulating layer 160. The second touch insulating layer 170 may include an inorganic insulating material and/or an organic insulating material. For example, the second touch insulating layer 170 may include silicon oxide (SiOₓ), silicon nitride (SiNₓ), silicon oxynitride (SiOₓN_{y}), or the like. These may be used alone or in combination with each other. A contact hole exposing a portion of the first touch electrode TE1 may be defined in the second touch insulating layer 170.

The second touch electrode TE2 may be arranged on the second touch insulating layer 170, and may overlap the first touch electrode TE1. In other words, the second touch electrode TE2 may be arranged in the non-emission area of the display device 1000. The second touch electrode TE2 may be electrically connected to the first touch electrode TE1 through the contact hole exposing a portion of the first touch electrode TE1.

The second touch electrode TE2 may include a conductive material such as a metal, an alloy, a conductive metal oxide, or the like. Examples of materials that may be used as the second touch electrode TE2 may include silver (Ag), alloys containing silver, molybdenum (Mo), alloys containing molybdenum, aluminium (Al), alloys containing aluminium, aluminium nitride (AIN), tungsten (W), tungsten nitride (WN), copper (Cu), nickel (Ni), chromium (Cr), chromium nitride (CrN), titanium (Ti), tantalum (Ta), platinum (Pt), scandium (Sc), or the like. They may be used alone or in combination with each other.

In some embodiments, the second touch electrode TE2 may have a multi-layer structure in which a plurality of conductive layers are stacked. For example, the second touch electrode TE2 may have a two-layer structure of titanium (Ti)/aluminium (Al), a two-layer structure of aluminium (Al)/molybdenum (Mo), a two-layer structure of titanium (Ti)/copper (Cu), or the like.

The first touch electrode TE1 and the second touch electrode TE2 may form a touch array. In some embodiments, the touch array may have a mesh structure in a plan view. However, the present disclosure is not necessarily limited thereto, and the structure of the touch array may vary.

In some embodiments, the reflective pattern RP may be arranged on the second touch insulating layer 170. For example, the reflective pattern RP may be arranged in a trench defined in the second touch insulating layer 170. In some embodiments, the reflective pattern RP may overlap the light emitting element LED in a plan view. The reflective pattern RP may reflect light emitted from the light emitting element LED. In addition, light reflected by the reflective pattern RP may be reflected again from structures under the reflective pattern RP (e.g., the common electrode CE, etc.) and emitted to the outside. Accordingly, the recycling efficiency of the light emitted from the light emitting element LED (i.e., the efficiency of light extraction from the light emitting element LED toward the outside) may be improved (e.g., increased).

In some embodiments, the reflective pattern RP may be formed together with the second touch electrode TE2. In other words, the reflective pattern RP may include the same material as the second touch electrode TE2. Examples of materials that may be used as the reflective pattern RP may include silver (Ag), alloys containing silver, molybdenum (Mo), alloys containing molybdenum, aluminium (Al), alloys containing aluminium, aluminium nitride (AIN), tungsten (W), tungsten nitride (WN), copper (Cu), nickel (Ni), chromium (Cr), chromium nitride (CrN), titanium (Ti), tantalum (Ta), platinum (Pt), scandium (Sc), or the like. These may be used alone or in combination with each other.

However, the present disclosure is not limited thereto, and in some other embodiments, the reflective pattern RP may be arranged on the first touch insulating layer 160 and may be covered by the second touch insulating layer 170. In other words, the reflective pattern RP may be formed together with the first touch electrode TE1, and may include the same material as the first touch electrode TE1.

In some embodiments, the reflective pattern RP may have a multi-layer structure in which a plurality of conductive layers are stacked. For example, the reflective pattern RP may have a two-layer structure of titanium (Ti)/aluminium (Al), a two-layer structure of aluminium (Al)/molybdenum (Mo), a two-layer structure of titanium (Ti)/copper (Cu), or the like.

The light blocking member BM may be arranged on the second touch insulating layer 170. In some embodiments, the light blocking member BM may entirely overlap the non-emission area and may have a grid shape in a plan view. In other words, the light blocking member BM may overlap the pixel defining layer 140 and the touch array in a plan view. In some embodiments, the light blocking member BM may cover the second touch electrode TE2 in a plan view. For example, the light blocking member BM may entirely cover the second touch electrode TE2.

In some embodiments, the light blocking member BM may absorb external light. Accordingly, the light blocking member BM may reduce the external light reflectance of the display device 1000. Examples of materials that may be used as the light blocking member BM may include chromium (Cr), chromium oxide (CrOₓ), chromium nitride (CrNₓ), carbon black, or the like. These may be used alone or in combination with each other.

In some embodiments, the light blocking member BM may define an opening area OA that exposes a portion of the second touch insulating layer 170. For example, the light blocking member BM may define the opening area OA corresponding to the pixel opening PO. In other words, the opening area OA may overlap the light emitting element LED in a plan view. In such examples, the opening area OA may overlap the reflective pattern RP in a plan view.

The light blocking pattern BP may be arranged on the second touch insulating layer 170. For example, the light blocking pattern BP may be arranged in the opening area OA defined by the light blocking member BM, and may cover the reflective pattern RP in a plan view. In other words, the light blocking pattern BP may overlap the reflective pattern RP in a plan view.

In some embodiments, the light blocking pattern BP may include the same material as the light blocking member BM. For example, examples of materials that may be used as the light blocking pattern BP may include chromium (Cr), chromium oxide (CrOₓ), chromium nitride (CrNₓ), carbon black, or the like. These may be used alone or in combination with each other.

In some embodiments, the light blocking pattern BP may be formed integrally with the light blocking member BM. The light blocking pattern BP and the light blocking member BM may be formed in the same process, for example, by applying a photoresist film on the second touch insulating layer 170 and selectively leaving the photoresist film in an area corresponding to the light blocking pattern BP and the light blocking member BM using an exposure mask or the like. However, the present disclosure is not necessarily limited thereto.

As illustrated in FIG. 2, the planar shape of the light blocking pattern BP may be circular. However, the present disclosure is not necessarily limited thereto, and in some other embodiments, the planar shape of the light blocking pattern BP may be elliptical, polygonal, track-shaped, or the like.

In some embodiments, the planar shape of the reflective pattern RP may be substantially the same as the planar shape of the light blocking pattern BP. That is, the planar shape of the reflective pattern RP may be circular, elliptical, polygonal, track-shaped, or the like.

The light blocking pattern BP may have a first width W1 of about 4 micrometers to about 20 micrometers (e.g., about 4 micrometers to about 15 micrometers) along one direction. For example, when the light blocking pattern BP has a circular planar shape, the light blocking pattern BP may have a circular planar shape having a diameter of about 4 micrometers to about 20 micrometers (e.g., about 4 micrometers to about 15 micrometers). As the first width W1 of the light blocking pattern BP satisfies the range described above, the recycling efficiency of the light emitted from the light emitting element LED may be further improved (e.g., increased).

In some embodiments, a plurality of light blocking patterns BP may correspond to the one light emitting element LED. That is, the plurality of light blocking patterns BP may be arranged in a dot shape for the one light emitting element LED. Accordingly, a light blocking pattern unit BPU corresponding to the one light emitting element LED may be defined. That is, the light blocking pattern unit BPU may include

(e.g., be) a set of the plurality of light blocking patterns BP corresponding to the one light emitting element LED. In such examples, a plurality of reflective patterns RP may correspond to the one light emitting element LED. That is, the plurality of reflective patterns RP may be arranged in a dot shape for the one light emitting element LED.

According to some embodiments of the present disclosure, the plurality of light blocking patterns BP may be arranged in a dot shape for the one light emitting element LED, and accordingly, the light blocking pattern unit BPU corresponding to the one light emitting element LED (which includes a set of the plurality of light blocking patterns BP) may be defined. Accordingly, a width of one light blocking pattern BP in one direction may be reduced. Accordingly, the recycling efficiency of the light emitted from the light emitting element LED may be further improved (e.g., increased) through the light blocking pattern unit BPU and the reflective pattern RP.

The color filter layer CF may be arranged on the second touch insulating layer 170 on which the light blocking member BM and the light blocking pattern BP are arranged. The color filter layer CF may be arranged in the opening area OA defined by the light blocking member BM. Accordingly, the color filter layer CF may cover the light blocking pattern BP. In some embodiments, the color filter layer CF may partially overlap the light blocking member BM. The color filter layer CF may transmit light of a specific color and block light of a color other than the specific color. The color of light emitted from the light emitting element LED may be more clearly recognized as the light passes through the color filter layer CF.

In some embodiments, the color filter layer CF may include a first color filter included in the first sub-pixel SPX1, a second color filter included in the second sub-pixel SPX2, and a third color filter included in the third sub-pixel SPX3. Each of the first to third color filters may transmit light of a specific color and block light of colors other than the specific color. For example, each of the first to third color filters may include a dye and/or pigment that absorbs light of a color other than the specific color.

In some embodiments, the color of light selectively transmitted by each of the first to third color filters may be determined according to the color of light emitted by the corresponding light emitting element. For example, when the light emitting element LED of the first sub-pixel SPX1 emits red light, the first color filter of the first sub-pixel SPX1 may be a red color filter that selectively transmits red light. In addition, when the light emitting element of the second sub-pixel SPX2 emits green light, the second color filter of the second sub-pixel SPX2 may be a green color filter that selectively transmits green light. In addition, when the light emitting element of the third sub-pixel SPX3 emits blue light, the third color filter of the third sub-pixel SPX3 may be a blue color filter that selectively transmits blue light.

The overcoat layer 180 may be arranged on the light blocking member BM and the color filter layer CF. The overcoat layer 180 may cover the light blocking member BM and the color filter layer CF. Accordingly, the reliability of the light blocking member BM and the color filter layer CF may be improved (e.g., increased). In some embodiments, the overcoat layer 180 may have a substantially flat upper surface. Accordingly, the overcoat layer 180 may compensate for a step difference of a lower surface. In some embodiments, the overcoat layer 180 may include an organic material. Examples of the organic material that may be used as the overcoat layer 180 may include photoresist, polyacrylic-based resin, polyimide-based resin, acrylic-based resin, epoxy-based resin, acrylate-based resin, or the like. These may be used alone or in combination with each other.

The window 190 may be arranged on the overcoat layer 180. The window 190 may include a transparent material. In some embodiments, examples of materials that may be used as the window 190 may include glass, quartz, plastic, or the like. These may be used alone or in combination with each other. The windows 190 may protect the above-described components from external force.

According to some embodiments of the present disclosure, the display device 1000 may not include a polarizer by including the light blocking member BM and the color filter layer CF. Accordingly, the weight and/or thickness of the display device 1000 may be reduced. In addition, the visibility of the display device 1000 may be improved (e.g., increased).

In addition, the display device 1000 may include the light blocking pattern BP covered by the color filter layer CF. The light blocking pattern BP may absorb external light. Accordingly, the external light reflectance of the display device 1000 may be reduced, and the reflected color may be improved (e.g., become less perceivable to a user). Accordingly, the display quality of the display device 1000 may be improved (e.g., increased).

In addition, the display device 1000 may include the reflective pattern RP covered by the light blocking pattern BP in a plan view. Accordingly, a portion of light emitted from the light emitting element LED may be reflected by the reflective pattern RP, and a portion of light reflected from the reflective pattern RP may be reflected again by the structures under the reflective pattern RP (e.g., the common electrode CE, etc.) and may be emitted to the outside. Accordingly, the recycling efficiency of light emitted from the light emitting element LED may be improved (e.g., increased).

In addition, according to some embodiments of the present disclosure, the plurality of light blocking patterns BP may be arranged in a dot shape for the one light emitting element LED, and accordingly, the light blocking pattern unit BPU corresponding to the one light emitting element LED (which includes a set of the plurality of light blocking patterns BP) may be defined. Accordingly, the width of the light blocking pattern BP in one direction may be reduced. Accordingly, the recycling efficiency of light emitted from the light emitting element LED may be further improved through the light blocking pattern unit BPU and the reflective pattern RP.

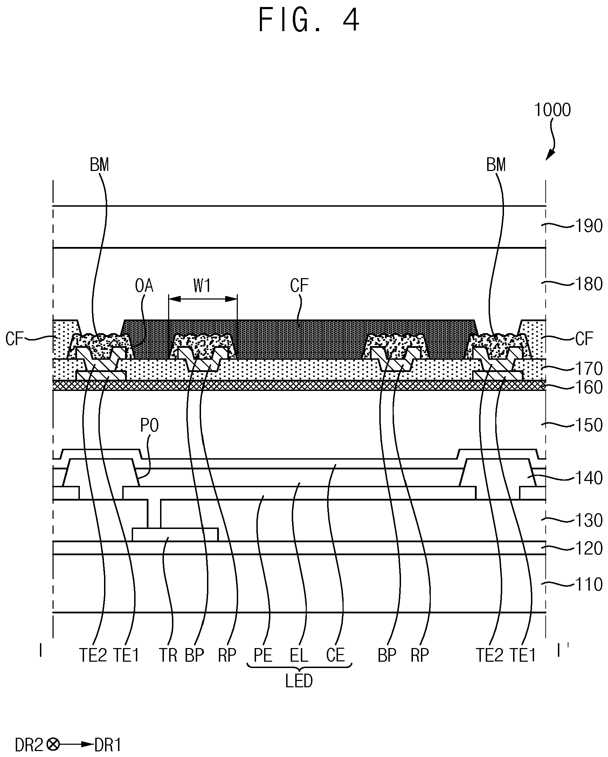

FIG. 4 is a cross-sectional view illustrating another example cut along the line I-I' of FIG. 2 according to some embodiments of the present disclosure. For example, FIG. 4 is a cross-sectional view illustrating another example of the light blocking pattern BP. Hereinafter, differences from an example of the light blocking pattern BP described above with reference to FIGS. 2 and 3 will be mainly described.

Referring to FIG. 4, in some embodiments, an upper surface of the light blocking pattern BP may have an uneven structure (e.g., a concave-convex structure). For example, a plasma treatment process, an etching process, or the like may be performed on the upper surface of the light blocking pattern BP to form the uneven structure on the upper surface of the light blocking pattern BP. When the upper surface of the light blocking pattern BP has the uneven structure, the surface roughness of the upper surface of the light blocking pattern BP may be improved (e.g., increased). Accordingly, the external light reflectance effect through the light blocking pattern BP may be further improved (e.g., increased). Accordingly, the display quality of the display device 1000 may be further improved (e.g., increased). In some embodiments in which the upper surface of the light blocking pattern BP has the uneven structure, an upper surface of the light blocking member BM may also have an uneven structure. However, the present disclosure is not necessarily limited thereto, and when the upper surface of the light blocking pattern BP has the uneven structure, the upper surface of the light blocking member BM may not have an uneven structure.

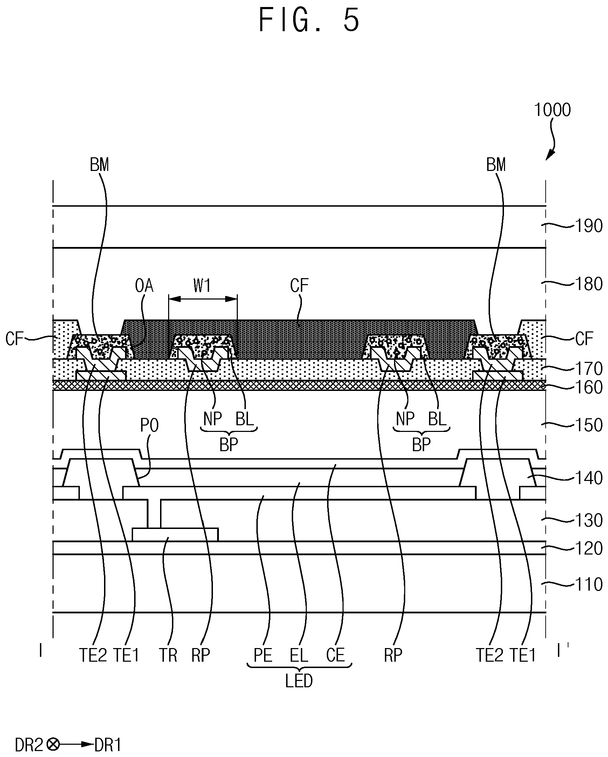

FIG. 5 is a cross-sectional view illustrating still another example cut along the line I-I' of FIG. 2 according to some embodiments of the present disclosure. For example, FIG. 5 is a cross-sectional view illustrating still another example of the light blocking pattern BP. Hereinafter, differences from an example of the light blocking pattern BP described above with reference to FIGS. 2 and 3 will be mainly described.

Referring to FIG. 5, in some embodiments, the light blocking pattern BP may include a base layer BL and scattering particles NP that are nano-sized and are dispersed within the base layer BL. The base layer BL may include a light blocking material. Examples of the light blocking material may include chromium (Cr), chromium oxide (CrOₓ), chromium nitride (CrNₓ), carbon black, or the like, as described above. The scattering particles NP may scatter or reflect light. The average size of each of the scattering particles NP may be about 50 nanometers to about 300 nanometers (e.g., about 50 nanometers to about 250 nanometers). When the size of each of the scattering particles NP satisfies the above range, the scattering particles NP may be more easily distributed/dispersed within the base layer BL.

In some embodiments, a content of the scattering particles NP included in the light blocking pattern BP may be less than about 5 wt% with respect to a total weight of the light blocking pattern BP. When the content of the scattering particles NP satisfies the above range, the path of light incident on the light blocking pattern BP may be more easily controlled, and the durability of the light blocking pattern BP may not be deteriorated.

In some embodiments, the scattering particles NP may include an inorganic material. Examples of the inorganic material that may be used as the scattering particles NP may include titanium oxide (TiO₂), zinc oxide (ZnO), aluminium oxide (Al₂O₃), zirconium oxide (ZrO₂), silicon oxide (SiO₂), or the like. They may be used alone or in combination with each other.

As the light blocking pattern BP includes the nano-sized scattering particles NP, scattering of external light may occur through the light blocking pattern BP. Accordingly, the external light reflectance effect through the light blocking pattern BP may be further improved (e.g., increased). Accordingly, the display quality of the display device 1000 may be further improved. In some embodiments in which the light blocking pattern BP includes the scattering particles NP, the light blocking member BM may also include the scattering particles NP. However, the present disclosure is not necessarily limited thereto, and when the light blocking pattern BP includes the scattering particles NP, the light blocking member BM may not include the scattering particles NP.

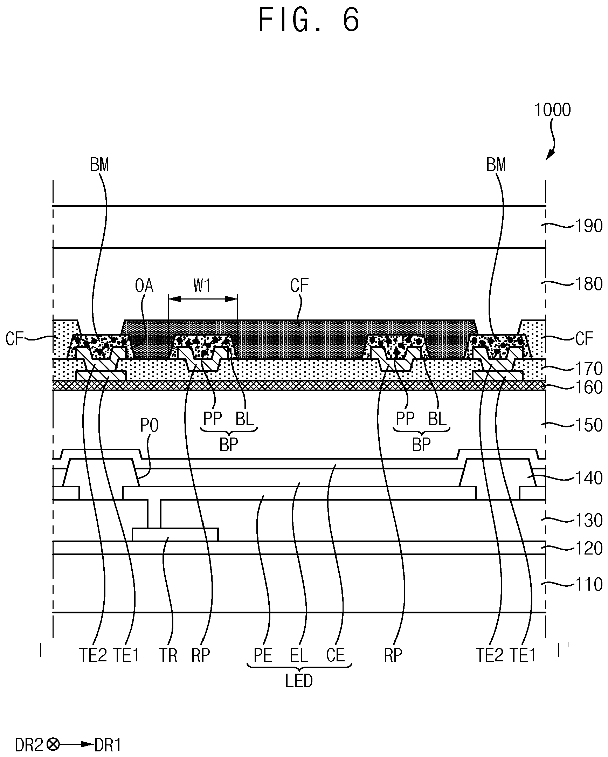

FIG. 6 is a cross-sectional view illustrating still another example cut along the line I-I' of FIG. 2 according to some embodiments of the present disclosure. For example, FIG. 6 is a cross-sectional view illustrating still another example of the light blocking pattern BP. Hereinafter, differences from an example of the light blocking pattern BP described above with reference to FIGS. 2 and 3 will be mainly described.

Referring to FIG. 6, in some embodiments, the light blocking pattern BP may include a base layer BL and pigment particles PP that are nano-sized and are dispersed within the base layer BL. The base layer BL may include a light blocking material. Examples of the light blocking material may include chromium (Cr), chromium oxide (CrOₓ), chromium nitride (CrNₓ), carbon black, or the like as described above. The pigment particles PP may absorb light. For example, the pigment particles PP may be black pigment particles. The average size of each of the pigment particles PP may be about 50 nanometers to about 300 nanometers (e.g., about 50 nanometers to about 250 nanometers). When the size of each of the pigment particles PP satisfies the above range, the pigment particles PP may be more easily distributed within the base layer BL.

In some embodiments, a content of the pigment particles PP included in the light blocking pattern BP may be less than about 5 wt% with respect to a total weight of the light blocking pattern BP. When the content of the pigment particles PP satisfies the above range, the path of light incident on the light blocking pattern BP may be more easily controlled, and the durability of the light blocking pattern BP may not be deteriorated.

As the light blocking pattern BP includes the nano-sized pigment particles PP, absorption of the external light may occur more readily through the pigment particles PP. Accordingly, the external light reflectance effect through the light blocking pattern BP may be further improved (e.g., increased). Accordingly, the display quality of the display device 1000 may be further improved. In some embodiments in which the light blocking pattern BP includes the pigment particles PP, the light blocking member BM may also include the pigment particles PP. However, the present disclosure is not necessarily limited thereto, and when the light blocking pattern BP includes the pigment particles PP, the light blocking member BM may not include the pigment particles PP.

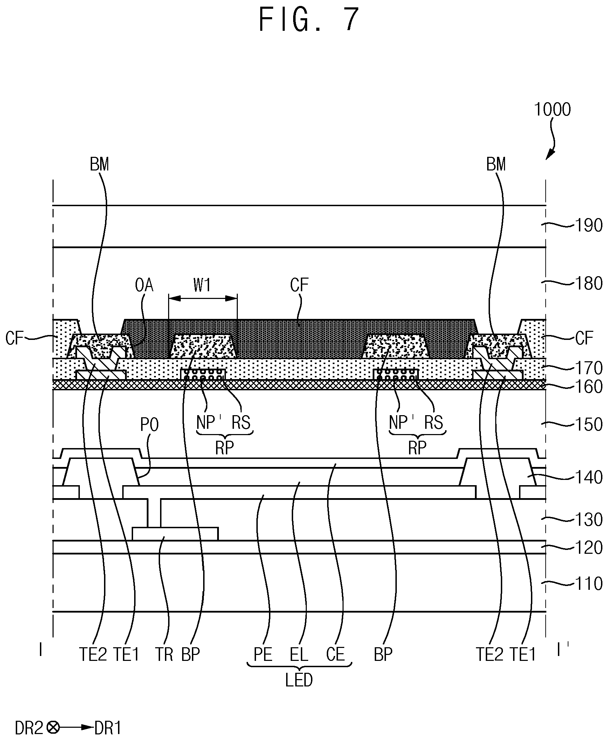

FIG. 7 is a cross-sectional view illustrating still another example cut along the line I-I' of FIG. 2 according to some embodiments of the present disclosure. For example, FIG. 7 is a cross-sectional view illustrating another example of the reflective pattern RP. Hereinafter, differences from an example of the reflective pattern RP described above with reference to FIGS. 2 and 3 will be mainly described.

Referring to FIG. 7, in some embodiments, the reflective pattern RP may be arranged on the first touch insulating layer 160 and may be covered by the second touch insulating layer 170. In some embodiments, the reflective pattern RP may include a resin layer RS and scattering particles NP' that are nano-sized and are dispersed within the resin layer RS. The resin layer RS may include an organic insulating material and/or an inorganic insulating material. The scattering particles NP' may scatter or reflect light. The average size of each of the scattering particles NP' may be about 50 nanometers to about 300 nanometers (e.g., about 50 nanometers to about 250 nanometers). When the size of each of the scattering particles NP' satisfies the above range, the scattering particles NP' may be more easily distributed within the resin layer RS.

In some embodiments, the scattering particles NP' may include an inorganic material. Examples of the inorganic material that may be used as the scattering particles NP' may include titanium oxide (TiO₂), zinc oxide (ZnO), aluminium oxide (Al₂O₃), zirconium oxide (ZrO₂), silicon oxide (SiO₂), or the like. They may be used alone or in combination with each other.

As the reflective pattern RP has a structure of the resin layer RS in which the nano-sized scattering particles NP' are dispersed, light scattering may occur through the reflective pattern RP. Accordingly, the path change of light may be more actively implemented between the reflective pattern RP and structures under the reflective pattern RP (e.g., the common electrode CE, etc.). Accordingly, the recycling efficiency of light emitted from the light emitting element LED may be further improved (e.g., increased). Accordingly, the display quality of the display device 1000 may be further improved.

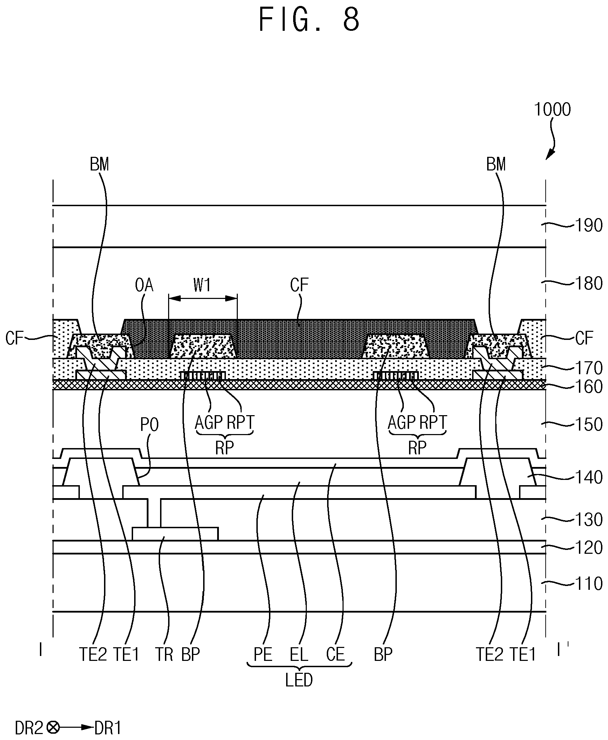

FIG. 8 is a cross-sectional view illustrating still another example cut along the line I-I' of FIG. 2 according to some embodiments of the present disclosure. For example, FIG. 8 is a cross-sectional view illustrating still another example of the reflective pattern RP. Hereinafter, differences between an example of the reflective pattern RP described above with reference to FIGS. 2 and 3 will be mainly described.

Referring to FIG. 8, in some embodiments, the reflective pattern RP may be arranged on the first touch insulating layer 160 and may be covered by the second touch insulating layer 170. In some embodiments, the reflective patterns RP may include resin patterns RPT and air gap patterns AGP.

The resin patterns RPT may be arranged on the first touch insulating layer 160, and may be arranged at an interval from each other. The resin patterns RPT may include an inorganic insulating material and/or an organic insulating material. In some embodiments, the resin patterns RPT may include the same material as the second touch insulating layer 170.

The air gap patterns AGP may be defined by the interval of the resin patterns RPT. That is, each of the air gap patterns AGP may refer to a space between the resin patterns RPT. An interior of the air gap patterns AGP may be filled with air.

A refractive index of the first touch insulating layer 160 may be greater than a refractive index of air within the air gap patterns AGP. For example, the refractive index of air within the air gap patterns AGP may be 1, and the refractive index of the first touch insulating layer 160 may be greater than 1.

As the reflective pattern RP has a patterning structure in which the resin patterns RPT and the air gap patterns AGP alternate, a refractive interface between the reflective pattern RP and the first touch insulating layer 160 may be defined. Accordingly, the path change of light may be more actively implemented between the reflective pattern RP and structures under the reflective pattern RP (e.g., the common electrode CE, etc.). Accordingly, the recycling efficiency of light emitted from the light emitting element LED may be further improved (e.g., increased). Accordingly, the display quality of the display device 1000 may be further improved.

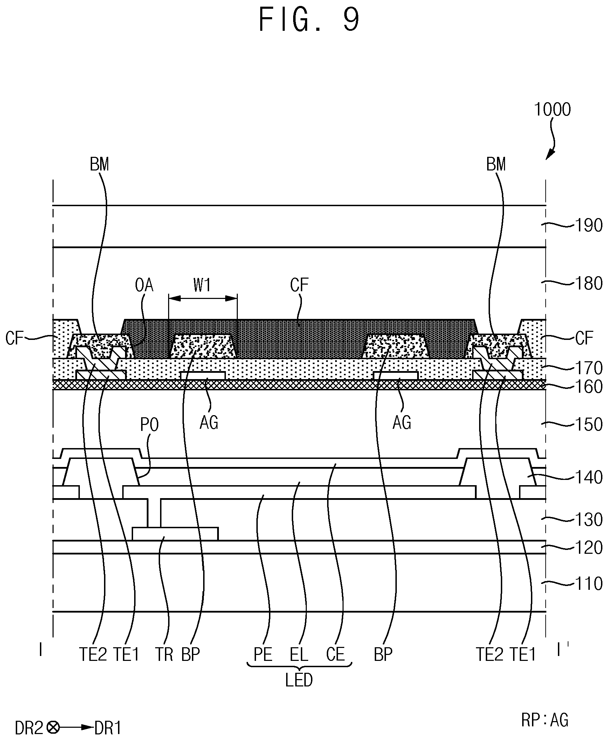

FIG. 9 is a cross-sectional view illustrating still another example cut along the line I-I' of FIG. 2 according to some embodiments of the present disclosure. For example, FIG. 9 is a cross-sectional view illustrating still another example of the reflective pattern RP. Hereinafter, differences from an example of the reflective pattern RP described above with reference to FIGS. 2 and 3 will be mainly described.

Referring to FIG. 9, in some embodiments, the reflective pattern RP may be arranged on the first touch insulating layer 160 and may be covered by the second touch insulating layer 170. In some embodiments, the reflective pattern RP may be an air gap AG defined between the first touch insulating layer 160 and the second touch insulating layer 170. The air gap AG may refer to a space between the first touch insulating layer 160 and the second touch insulating layer 170. An interior of the air gap AG may be filled with air.

The refractive index of the first touch insulating layer 160 may be greater than the refractive index of air within the air gap AG. For example, the refractive index of air within the air gap AG may be 1, and the refractive index of the first touch insulating layer 160 may be greater than 1.

When the reflective pattern RP is the air gap AG, a refractive interface between the reflective pattern RP and the first touch insulating layer 160 may be defined. Accordingly, the path change of light may be more actively implemented between the reflective pattern RP and structures under the reflective pattern RP (e.g., the common electrode CE, etc.). Accordingly, the recycling efficiency of light emitted from the light emitting element LED may be further improved (e.g., increased). Accordingly, the display quality of the display device 1000 may be further improved.

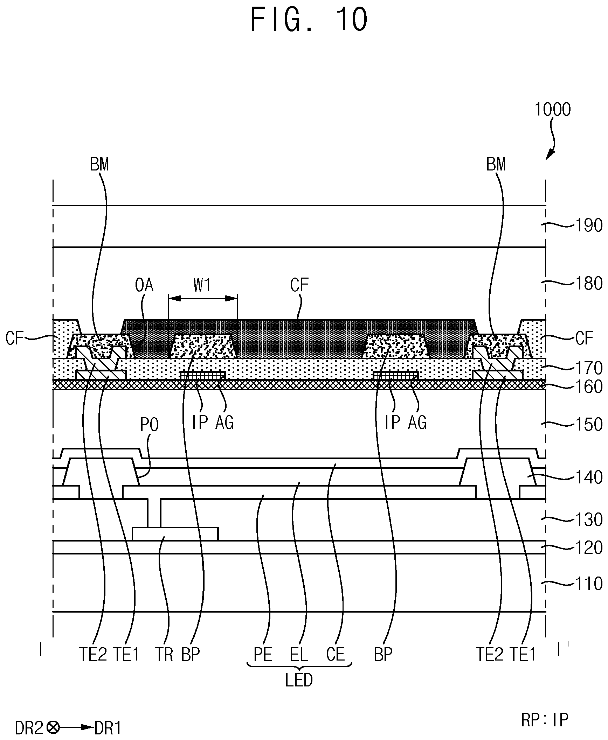

FIG. 10 is a cross-sectional view illustrating still another example cut along the line I-I' of FIG. 2 according to some embodiments of the present disclosure. For example, FIG. 10 is a cross-sectional view illustrating still another example of the reflective pattern RP. Hereinafter, differences from an example of the reflective pattern RP described above with reference to FIGS. 2 and 3 will be mainly described.

Referring to FIG. 10, in some embodiments, the reflective pattern RP may be arranged on the first touch insulating layer 160 and may be covered by the second touch insulating layer 170. In some embodiments, the reflective pattern RP may be an insulating pattern IP that is arranged to fill an air gap AG defined between the first touch insulating layer 160 and the second touch insulating layer 170. As described above, the air gap AG may refer to a space between the first touch insulating layer 160 and the second touch insulating layer 170. An interior of the air gap AG may be filled with the insulating pattern IP.

The insulating pattern IP may include an inorganic insulating material and/or an organic insulating material. In some embodiments, the insulating pattern IP may include a different material from the first touch insulating layer 160. In some embodiments, the insulating pattern IP may include a different material from the second touch insulating layer 170.

In some embodiments, the refractive index of the first touch insulating layer 160 may be greater than a refractive index of the insulating pattern IP. For example, the refractive index of the insulating pattern IP may be about 1.3 to about 1.4, and the refractive index of the first touch insulating layer 160 may be greater than the refractive index of the insulating pattern IP.

In some embodiments, a refractive index of the second touch insulating layer 170 may be smaller than the refractive index of the insulating pattern IP. For example, the refractive index of the insulating pattern IP may be about 1.6 to 1.9, and the refractive index of the second touch insulating layer 170 may be smaller than the refractive index of the insulating pattern IP.

When the reflective pattern RP is the insulating pattern IP that is arranged to fill the air gap AG defined between the first touch insulating layer 160 and the second touch insulating layer 170, a refractive interface between the reflective pattern RP and the first touch insulating layer 160 and/or a refractive interface between the reflective pattern RP and the second touch insulating layer 170 may be defined. Accordingly, the path change of light may be more actively implemented between the reflective pattern RP and structures under the reflective pattern RP (e.g., the common electrode CE, etc.). Accordingly, the recycling efficiency of light emitted from the light emitting element LED may be further improved (e.g., increased). Accordingly, the display quality of the display device 1000 may be further improved.

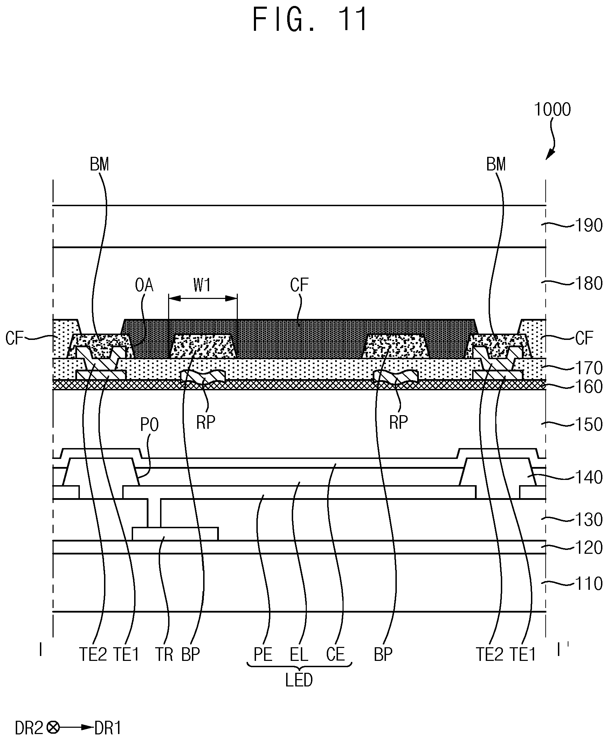

FIG. 11 is a cross-sectional view illustrating still another example cut along the line I-I' of FIG. 2 according to some embodiments of the present disclosure. For example, FIG. 11 is a cross-sectional view illustrating still another example of the reflective pattern RP. Hereinafter, differences from an example of the reflective pattern RP described above with reference to FIGS. 2 and 3 will be mainly described.

Referring to FIG. 11, in some embodiments, a lower surface of the reflective pattern RP may have an uneven structure. That is, the lower surface of the reflective pattern RP may not be flat. In FIG. 11, the reflective pattern RP is illustrated as being arranged on the first touch insulating layer 160 and including a conductive material, but the present disclosure is not necessarily limited thereto. For example, in some embodiments in which the lower surface of the reflective pattern RP has an uneven structure, the reflective pattern RP may have any one of the structures described above with reference to FIGS. 3, 7, 8, 9, and 10.

As the lower surface of the reflective pattern RP has an uneven structure, the path change of light may be more actively implemented between the reflective pattern RP and structures under the reflective pattern RP (e.g., the common electrode CE, etc.). Accordingly, the recycling efficiency of light emitted from the light emitting element LED may be further improved (e.g., increased). Accordingly, the display quality of the display device 1000 may be further improved.

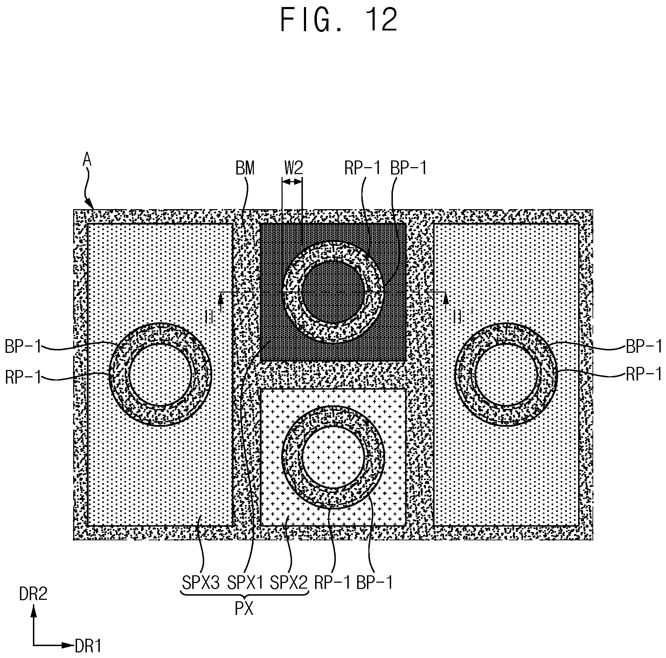

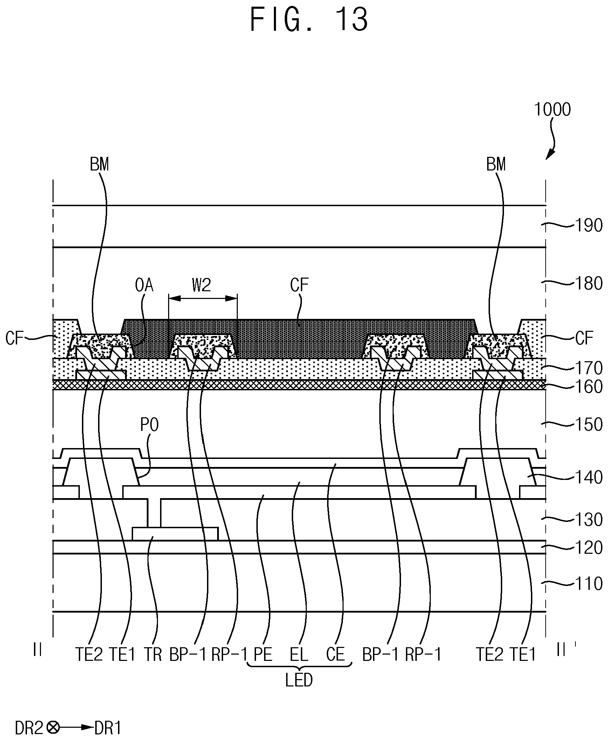

FIG. 12 is an enlarged view illustrating another example of area A of FIG. 1. FIG. 13 is a cross-sectional view illustrating an example cut along the line II-II' of FIG. 12 according to some embodiments of the present disclosure.

The display device 1000 described with reference to FIGS. 12 and 13 may be substantially the same as the display device 1000 described with reference to FIGS. 2 to 11, except for a light blocking pattern BP-1 and a reflective pattern RP-1. In addition, the description of the light blocking pattern BP described above may be applied to the light blocking pattern BP-1, except for the planar shape. In addition, the description of the reflective pattern RP described above may be applied to the reflective pattern RP-1, except for the planar shape. Therefore, hereinafter, the redundant description may be omitted.

Referring to FIGS. 12 and 13, in some embodiments, the planar shape of the light blocking pattern BP-1 may be a ring shape. For example, the planar shape of the light blocking pattern BP-1 may be a circular ring shape. For example, the planar shape of the light blocking pattern BP-1 may be a concentric ring shape.

In some embodiments, the planar shape of the reflective pattern RP-1 may be substantially the same as the planar shape of the light blocking pattern BP-1. That is, the planar shape of the reflective pattern RP-1 may be a ring shape. For example, the planar shape of the reflective pattern RP-1 may be a circular ring shape. For example, the planar shape of the reflective pattern RP-1 may be a concentric ring shape.

The light blocking pattern BP-1 may have a second width W2 of about 4 micrometers to about 20 micrometers along one direction (e.g., about 4 micrometers to about 15 micrometers). For example, when the planar shape of the light blocking pattern BP-1 is a concentric ring shape, a difference between a radius of an outer circumferential surface and a radius of an inner circumferential surface may be about 4 micrometers to about 20 micrometers (e.g., about 4 micrometers to about 15 micrometers). As the second width W2 of the light blocking pattern BP-1 satisfies the above-described range, the recycling efficiency of light emitted from the light emitting element LED may be further improved (e.g., increased).

According to some embodiments of the present disclosure, the light blocking pattern BP-1 may be arranged in a ring shape for one light emitting element LED, and accordingly, the width of the light blocking pattern BP-1 in the one direction may be reduced. Accordingly, the recycling efficiency of light emitted from the light emitting element LED may be further improved through the light blocking pattern BP-1 and the reflective pattern RP-1.

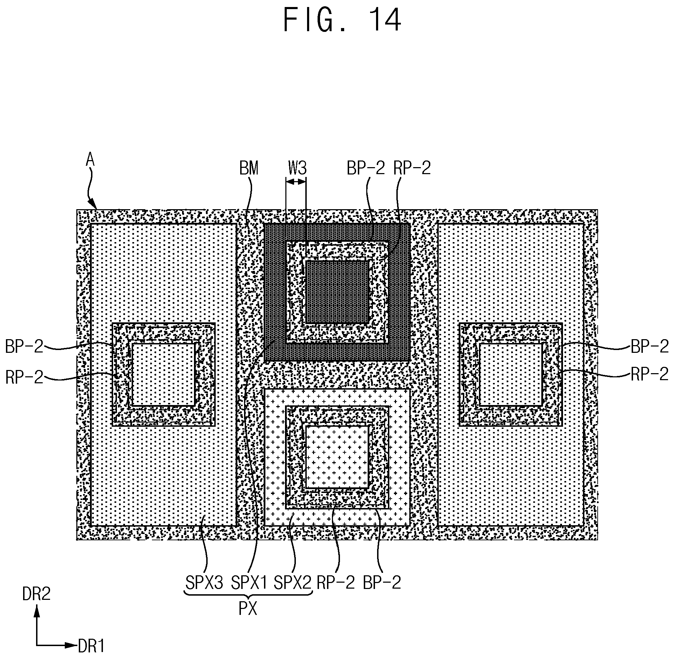

FIG. 14 is an enlarged view illustrating still another example of area A of FIG. 1.

The display device 1000 described with reference to FIG. 14 may be substantially the same as the display device 1000 described above with reference to FIGS. 2 to 11, except for a light blocking pattern BP-2 and a reflective pattern RP-2. In addition, the description of the light blocking pattern BP described above may be applied to the light blocking pattern BP-2, except for the planar shape. In addition, the description of the reflective pattern RP described above may be applied to the reflective pattern RP-2, except for the planar shape. Accordingly, hereinafter, the redundant description may be omitted.

Referring to FIG. 14, in some embodiments, the planar shape of the light blocking pattern BP-2 may be a rectangular ring shape. In some embodiments, the planar shape of the reflective pattern RP-2 may be substantially the same as the planar shape of the light blocking pattern BP-2. That is, the planar shape of the reflective pattern RP-2 may be a rectangular ring shape.

The light blocking pattern BP-2 may have a third width W3 of about 4 micrometers to about 20 micrometers (e.g., about 4 micrometers to about 15 micrometers along one direction). As the third width W3 of the light blocking pattern BP-2 satisfies the above-described range, the recycling efficiency of light emitted from the light emitting element LED may be further improved.

According to some embodiments of the present disclosure, the light blocking pattern BP-2 may be arranged in a ring shape for one light emitting element LED, and accordingly, the width of the light blocking pattern BP-2 in the one direction may be reduced. Accordingly, the recycling efficiency of light emitted from the light emitting element LED may be further improved through the light blocking pattern BP-2 and the reflective pattern RP-2.

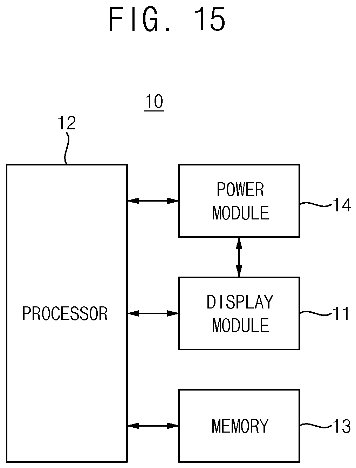

FIG. 15 is a block diagram of an electronic device according to some embodiments of the present disclosure.

Referring to FIG. 15, an electronic device 10 according to some embodiments may include a display module 11, a processor 12, a memory 13, and a power module 14. The display device according to some embodiments may be applied to a variety of electronic devices. The electronic device 10 according to some embodiments may include the display device described above, and may further include modules or devices having other additional functions in addition to the display device.

The processor 12 may include at least one of a central processing unit ("CPU"), an application processor ("AP"), a graphic processing unit ("GPU"), a communication processor ("CP"), an image signal processor ("ISP"), and a controller.

The memory 13 may store data information utilized for operation of the processor 12 or the display module 11. When the processor 12 executes an application stored in the memory 13, an image data signal and/or an input control signal may be transmitted to the display module 11, and the display module 11 may process the received signals and may output image information through a display screen.

The power module 14 may include a power supply module, such as a power adapter, a battery device, or the like, and a power conversion module that converts power supplied by the power supply module to generate the power utilized for operation of the electronic device 10. That is, the power module 14 may provide power to the display device according to the embodiments described above.

At least one of the components of the electronic device 10 described above may be included in the display device according to the embodiments described above. In addition, some of the individual modules that are functionally included in one module may be included in the display device and others may be provided separately from the display device. For example, the display device may include the display module 11, and the processor 12, the memory 13, and the power module 14 may be provided in the form of other devices in the electronic device 10 other than the display device.

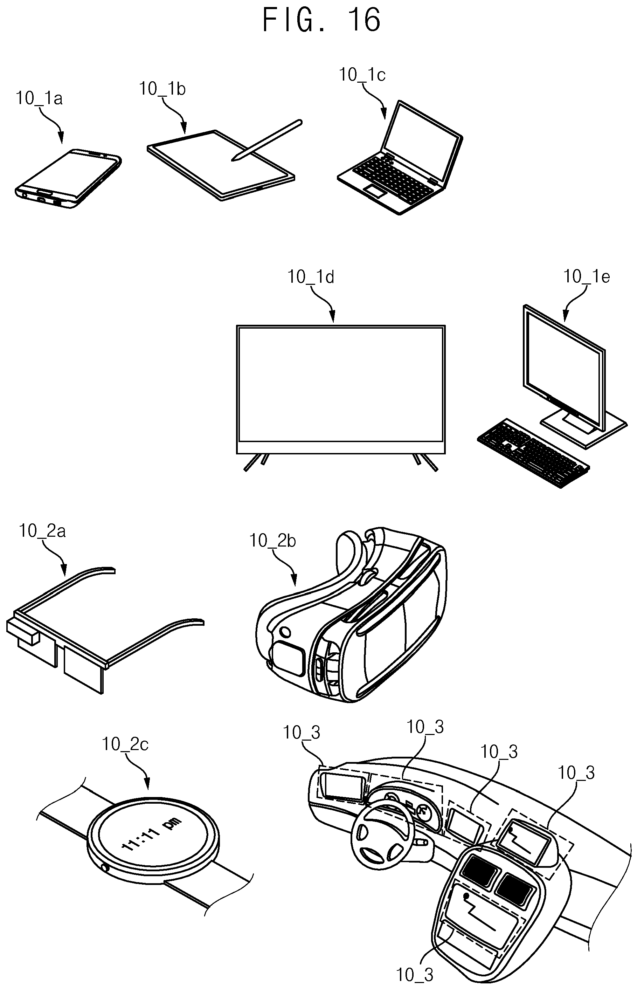

FIG. 16 is a schematic diagram of an electronic device according to some embodiments of the present disclosure.

Referring to FIG. 16, various electronic devices to which a display device according to some embodiments is applied may include image display electronic devices such as a smartphones 10_1a, a tablet PC 10_1b, a laptop 10_1c, a television 10_1d, a desk monitor 10_1e, or the like, wearable electronic devices including display modules such as a smart glasses 10_2a, a head-mounted display 10_2b, and a smart watch 10_2c, or the like, and vehicle electronic devices (10_3) including display modules such as a CID (center information display), which may be disposed on an instrument panel, a center fascia, and a dashboard of an automobile and a room mirror display, etc.

The present disclosure may be applied to various display devices. For example, the present disclosure is applicable to various display devices such as display devices for vehicles, ships and aircraft, portable communication devices, display devices for exhibition or information transmission, medical display devices, and the like.

The foregoing is illustrative of some embodiments of the present disclosure, and is not to be construed as limiting thereof. Although a few embodiments have been described with reference to the figures, those skilled in the art will readily appreciate that many variations and modifications may be made therein without departing from the scope of the present disclosure as defined by the appended claims and equivalents thereof.

## Claims

1. A display device (1000) comprising:
a light emitting element (LED) comprising a pixel electrode (PE);
a pixel defining layer (140) defining a pixel opening (PO) exposing at least a portion of the pixel electrode (PE);
a light blocking pattern (BP, BP-1, BP-2) arranged on the light emitting element (LED), overlapping the pixel opening (PO) in a plan view, and having a width (W1, W2, W3) of about 4 micrometers to about 20 micrometers in one direction (DR1); and
a reflective pattern (RP, RP-1, RP-2) arranged on the light emitting element (LED), overlapping the pixel opening (PO) in the plan view, and covered by the light blocking pattern (BP, BP-1, BP-2) in the plan view.

2. The display device (1000) of claim 1, wherein the light blocking pattern (BP, BP-1, BP-2) has a width (W1, W2, W3) of about 4 micrometers to about 15 micrometers in the one direction (DR1).

3. The display device (1000) of claim 1 or claim 2, wherein:
(i) a planar shape of the light blocking pattern (BP-1) is a ring shape; or
(ii) a light blocking pattern unit (BPU) comprises a set of the light blocking patterns (BP, BP-1, BP-2), and
wherein the light blocking pattern unit (BPU) overlaps the pixel opening (PO) in the plan view.

4. The display device (1000) of any one of claims 1 to 3, wherein an upper surface of the light blocking pattern (BP, BP-1, BP-2) has an uneven structure.

5. The display device (1000) of any one of claims 1 to 4, wherein the light blocking pattern (BP) comprises:
(i) a base layer (BL) comprising a light blocking material; and
scattering particles (NP) that are nano-sized and are dispersed within the base layer (BL); or
(ii) a base layer (BL) comprising a light blocking material; and
pigment particles (PP) that are nano-sized and are dispersed within the base layer (BL).

6. The display device (1000) of any one of claims 1 to 5, further comprising:
a first touch insulating layer (160) arranged on the light emitting element (LED);
a first touch electrode (TE1) arranged on the first touch insulating layer (160);
a second touch insulating layer (170) covering the first touch electrode (TE1); and
a second touch electrode (TE2) arranged on the second touch insulating layer (170) and electrically connected to the first touch electrode (TE1),
wherein the light blocking pattern (BP, BP-1, BP-2) is arranged on the second touch insulating layer (170).

7. The display device (1000) of claim 6, wherein the reflective pattern (RP, RP-1, RP-2) comprises a conductive material.

8. The display device (1000) of claim 6, wherein the reflective pattern (RP) comprises:
a resin layer (RS) arranged on the first touch insulating layer (160) and covered by the second touch insulating layer (170); and
scattering particles (NP') that are nano-sized and are dispersed within the resin layer (RS).

9. The display device (1000) of claim 6, wherein the reflective pattern (RP) comprises:
resin patterns (RPT) arranged on the first touch insulating layer (160) and arranged at an interval from each other; and
air gap patterns (AGP) defined by the interval of the resin patterns (RPT), optionally wherein a refractive index of the first touch insulating layer (160) is greater than a refractive index of air within the air gap patterns (AGP).

10. The display device (1000) of claim 6, wherein the reflective pattern (RP) is an air gap (AG) defined between the first touch insulating layer (160) and the second touch insulating layer (170), and
wherein a refractive index of the first touch insulating layer (160) is greater than a refractive index of air within the air gap (AG).

11. The display device (1000) of claim 6, wherein the reflective pattern (RP) is an insulating pattern (IP) arranged to fill an air gap (AG) defined between the first touch insulating layer (160) and the second touch insulating layer (170), and
wherein a refractive index of the first touch insulating layer (160) is greater than a refractive index of the insulating pattern (IP), or a refractive index of the second touch insulating layer (170) is smaller than the refractive index of the insulating pattern (IP).

12. The display device (1000) of any one of claims 1 to 7, wherein a lower surface of the reflective pattern (RP) has an uneven structure.

13. The display device (1000) of any one of claims 1 to 12, further comprising:
a light blocking member (BM) arranged on the pixel defining layer (140), overlapping the pixel defining layer (140) in the plan view, and defining an opening area (OA) corresponding to the pixel opening (PO); and
a color filter layer (CF) arranged in the opening area (OA) and configured to selectively transmit light of a specific color,
wherein the light blocking pattern (BP, BP-1, BP-2) is arranged in the opening area (OA) and is covered by the color filter layer (CF), optionally wherein the light blocking pattern (BP, BP-1, BP-2) comprises a same material as the light blocking member (BM).

14. A display device (1000) comprising:
a light emitting element (LED) comprising a pixel electrode (PE);
a pixel defining layer (140) defining a pixel opening (PO) exposing at least a portion of the pixel electrode (PE);
a light blocking member (BM) arranged on the pixel defining layer (140), overlapping the pixel defining layer (140) in a plan view, and defining an opening area (OA) corresponding to the pixel opening (PO);
a light blocking pattern unit (BPU) arranged in the opening area (OA) on the light emitting element (LED), overlapping the pixel opening (PO) in the plan view, and defined by a set of light blocking patterns (BP, BP-1, BP-2);
a color filter layer (CF) arranged in the opening area (OA) on the light emitting element (LED), configured to selectively transmit light of a specific color, and covering the light blocking pattern unit (BPU); and
a reflective pattern (RP, RP-1, RP-2) arranged on the light emitting element (LED), overlapping the pixel opening (PO) in the plan view, and covered by the light blocking pattern unit (BPU) in the plan view, optionally wherein each of the light blocking patterns (BP, BP-1, BP-2) has a width (W1, W2, W3) of about 4 micrometers to about 20 micrometers in one direction (DR1), and
wherein a planar shape of each of the light blocking patterns (BP, BP-1, BP-2) is circular, elliptical, polygonal, or track-shaped.

15. An electronic device (10) comprising:
a display device (1000) comprising a light emitting element (LED); and
a power module (14) configured to provide power to the display device (1000),
wherein the display device (1000) comprises:
the light emitting element (LED) comprising a pixel electrode (PE);
a pixel defining layer (140) defining a pixel opening (PO) exposing at least a portion of the pixel electrode (PE);
a light blocking pattern (BP, BP-1, BP-2) arranged on the light emitting element (LED), overlapping the pixel opening (PO) in a plan view, and having a width (W1, W2, W3) of about 4 micrometers to about 20 micrometers in one direction (DR1); and
a reflective pattern (RP, RP-1, RP-2) arranged on the light emitting element (LED), overlapping the pixel opening (PO) in the plan view, and covered by the light blocking pattern (BP, BP-1, BP-2) in the plan view.
